# EUROPEAN PATENT APPLICATION

(11) **EP 4 765 200 A1**
(43) Date of publication of application: **24.06.2026**
(21) Application number: 24854129.4
(22) Date of filing: 31.07.2024
(51) Int. Cl.: H01L 23/28, H01L 23/00, H01Q 13/16, H05K 1/02, H05K 9/00

(54) **ELECTRONIC COMPONENT AND METHOD FOR PRODUCING ELECTRONIC COMPONENT**

(30) Priority: 15.08.2023 JP 2023132282
(71) Applicant: FDK Corporation, Tokyo 108-8212 (JP)
(72) Inventor: KUMAGAI, Takayuki, Tokyo 108-8212 (JP); SUZUKI, Jun, Tokyo 108-8212 (JP); SAITO, Yoshiro, Tokyo 108-8212 (JP); ATSUMI, Naoki, Tokyo 108-8212 (JP); KIDA, Shingo, Tokyo 108-8212 (JP); YAMAGATA, Noriyuki, Tokyo 108-8212 (JP); YAMADA, Keiju, Kawasaki-shi, Kanagawa 212-8585 (JP)
(74) Representative: Bjerkén Hynell KB
(86) International application number: PCT/JP2024/027336
(87) International publication number: WO 2025/037538

(57) **Abstract**

This electronic component comprises a substrate which is provided with: a circuit component; a conductor that is conductively connected to a conductive component of a shield that shields the circuit component from the outside; and a conductive member that is in contact with both the conductive component and the conductor. The conductive member and the conductive component are alloyed.

## Description

### Technical Field

The present invention relates to an electronic component and a method for producing the electronic component.

### Background Art

An electronic component in which a circuit board with various circuit components mounted thereon is sealed with a resin and a surface of the resin is coated with an electromagnetic wave shielding material has been known in the related art. The purpose of the above configuration is to prevent the intrusion of electromagnetic waves into the sealed interior. As electromagnetic wave shielding materials, metal thin films formed by vapor deposition, plating, or the like, as well as conductive resins containing metal fillers, are often used.

For example, PTL 1 and PTL 2 disclose the configuration of a circuit module, which is an example of the electronic component. In each circuit module, a conductor portion located at the side end portion of a printed circuit board (PCB) and a conductive component contained in a shield are conductively connected to each other.

In the circuit module described in PTL 2, the conductor portion located at the side end portion of the PCB and the conductive component contained in the shield are conductively connected to each other via solder.

### Citation List

### Patent Literature

PTL 1
   Japanese Patent Application Laid-Open No. 2004-172176
PTL 2
   WO2015/194435

### Summary of Invention

### Technical Problem

In the above-described electronic component in the related art, the conductive connection between the conductor portion of the board and the conductive component of the shield is formed by the contact between the conductor portion and the conductive component. Here, the side end surface of the conductor portion that comes into contact with the shield is a cut surface formed by groove processing on the board, and there is a risk that this cut surface may not become flat at a microscopic level. On the other hand, the conductive component of the shield is embedded in a resin of a base material constituting the shield, but the conductive component exposed on the inner wall surface of the shield that comes into contact with the conductor portion of the board is distributed in a speckled manner at a microscopic level.

As described above, when the conductive connection is formed by the contact between the conductor portion of the board, which is not flat, and the conductive component of the shield, which is distributed in a speckled manner, there is a problem such that individual differences in the conductive connection are more likely to occur. In addition, when the electronic component is, for example, for a high-frequency signal, individual differences in the high frequency characteristics of the electronic component are more likely to occur. Furthermore, there is a problem that connection resistance between the conductor portion of the board and the conductive component of the shield may change due to a thermal history or the like after the electronic component is completed.

These problems still remain in the case where the conductive connection is formed via a solder as in PTL 2 as long as the side end surface of the solder that contacts the shield is a cut surface. That is, in the above-described electronic component in the related art, there is a certain limit to improving the connection reliability between the board and the shield.

An object of the present invention is to provide an electronic component and a method for producing the electronic component, both capable reliably improving the connection reliability between a board and a shield.

### Solution to Problem

One aspect of the electronic component according to the present invention includes:
a board provided with a circuit component, a conductor, and a conductive member, the conductor being conductively connected to a conductive component of a shield shielding the circuit component from an outside of the electronic component, the conductive member being in contact with both the conductive component and the conductor, in which
the conductive member is alloyed with the conductive component.

One aspect of the method for producing an electronic component according to the present invention includes:
preparing a board provided with a circuit component, a conductor, and a conductive member, the conductor being conductively connected to a conductive component of a shield shielding the circuit component from an outside of the electronic component, the conductive member being in contact with both the conductive component and the conductor; and
heat-treating the board at a temperature exceeding a melting point of the conductive member to alloy the conductive member with the conductive component.

### Advantageous Effects of Invention

The present invention can reliably improve the connection reliability between a board and a shield.

### Brief Description of Drawings

FIG. 1A schematically illustrates the appearance of an electronic component according to Embodiment 1, and FIGS. 1B and 1C schematically illustrate the configurations of the front surface side and the back surface side of a circuit board in the electronic component;
FIG. 2 illustrates a longitudinal sectional view and an enlarged view of a main part illustrating an internal configuration of the electronic component according to Embodiment 1;
FIG. 3 is a diagram for describing the configuration of a ground electrode in the electronic component according to Embodiment 1;
FIGS. 4A to 4F illustrate steps of a method for producing the electronic component according to Embodiment 1 in an execution order;
FIGS. 5A and 5B are SEM images capturing contact states in the electronic component according to a conventional example and in the electronic component according to Embodiment 1 between the ground electrode and the conductive component of the shield;
FIG. 6 is a graph for comparing a change in connection resistance due to a thermal history between the electronic component according to a conventional example and the electronic component according to Embodiment 1;
FIG. 7 is a diagram for describing a schematic configuration of an electronic component according to Embodiment 2; and
FIG. 8 schematically illustrates the configuration of the front surface side of a circuit board in the electronic component according to Embodiment 2.

### Description of Embodiments

Hereinafter, embodiments of the present invention will be described in detail with reference to the drawings.

### (Embodiment 1)

### (Configuration of Electronic Component)

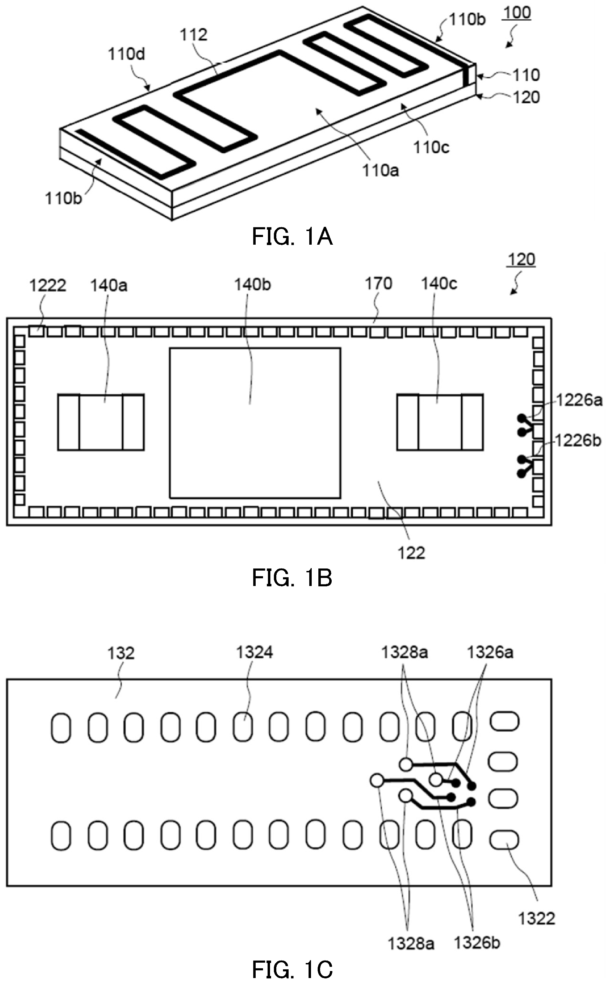

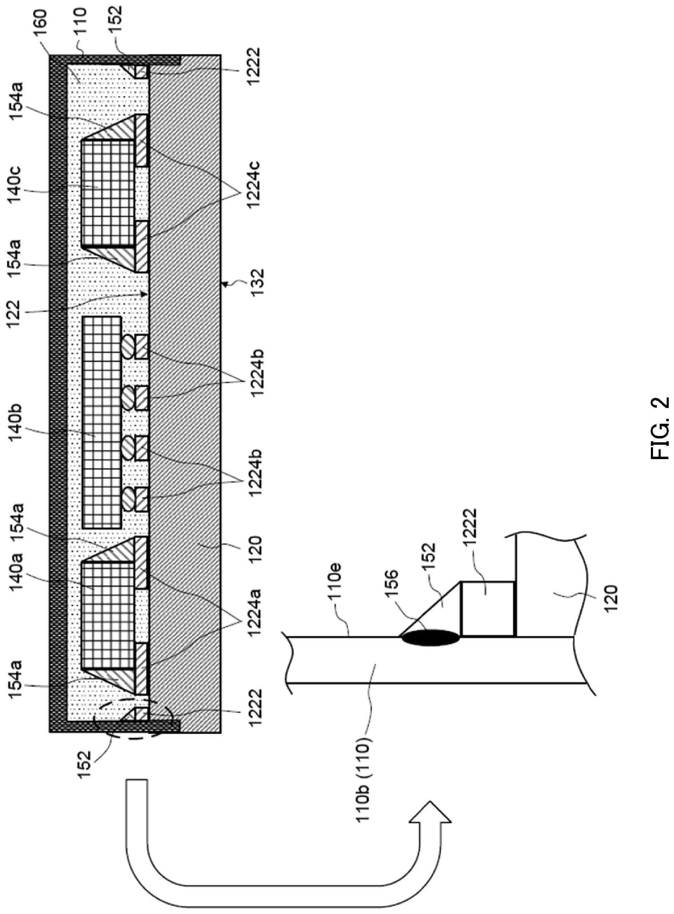

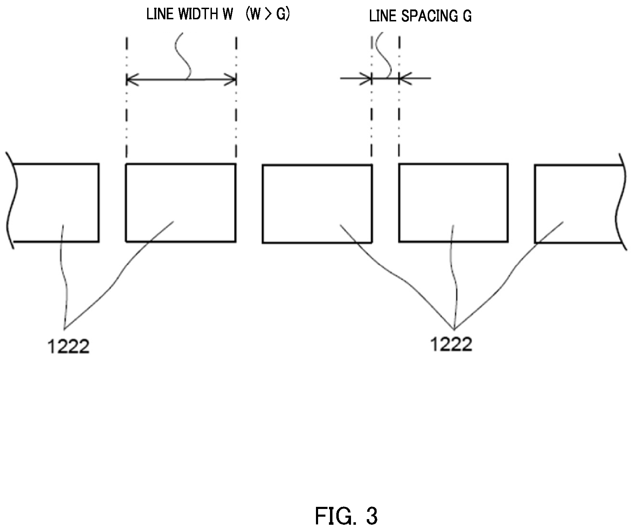

FIG. 1A schematically illustrates the appearance of an electronic component according to Embodiment 1, and FIGS. 1B and 1C schematically illustrate the configurations of the front surface side and the back surface side of a circuit board in the electronic component. FIG. 2 illustrates a longitudinal sectional view and an enlarged view of a main part illustrating an internal configuration of the electronic component according to the present embodiment. FIG. 3 is a diagram for describing the configuration of an electrode for ground (hereinafter also referred to as "ground electrode") in the electronic component according to the present embodiment.

In the present embodiment, the case where electronic component 100 is a wireless module with a slot antenna will be described as an example. However, an application example of electronic component 100 is not limited to the wireless module with a slot antenna.

Electronic component 100 includes shield 110 and circuit board 120.

Shield 110 is a box-shaped lid having a long rectangular shape in plan view that matches a long rectangular shape of circuit board 120. Shield 110 has a function of shielding circuit components 140a, 140b, and 140c disposed on circuit board 120 from the outside of the electronic component. Shield 110 is made of a conductive resin material. The conductive resin material is a material obtained by mixing a metal filler into an insulating resin material serving as a base material. A metal material that serves as the conductive component of shield 110 is, for example, Cu or Ag.

A pattern of slot 112 is formed on an outer surface of shield 110 (in the present embodiment, top surface portion 110a and front wall portion 110c). Slot 112 is a groove that forms, in the outer surface of shield 110, a void that is free of conductive components. The groove may be used for engraving characters or the like, but in the present embodiment, the groove is used as slot 112 for realizing the slot antenna.

In the present embodiment, circuit board 120 is a multilayer printed circuit board that is a flat plate having a long rectangular shape and that has a multilayer wiring pattern (not illustrated) formed thereon. Any configuration that is well known in the related art can be used as the configuration of the multilayer printed circuit board, and therefore the detailed description thereof will be omitted here.

On a layer on the front surface 122 side of circuit board 120 (hereinafter, referred to as a "front surface layer" that is an example of a first layer), circuit components 140a, 140b, and 140c are disposed by reflow mounting with solder 154a, solder 154b, and solder 154c. Each of circuit components 140a, 140b, and 140c are, for example, a semiconductor device or a chip component. In the present embodiment, circuit component 140b is a semiconductor device that handles a high-frequency signal, circuit component 140a is a chip capacitor, and circuit component 140c is a chip inductor.

A large number of electrodes are disposed on the front surface layer. The electrodes disposed on the front surface layer include ground electrode 1222 and electrodes for terminal connection (hereinafter also referred to as "terminal-connection electrodes") 1224a, 1224b, and 1224c. In FIGS. 2 and the like, ground electrode 1222 and terminal-connection electrodes 1224a, 1224b, and 1224c disposed on the front surface layer are disposed so as to protrude upward from the front surface layer of circuit board 120, but may be disposed in such a way that the electrodes are embedded in the front surface layer of circuit board 120 and the top surfaces of the electrodes face upward.

Terminal-connection electrodes 1224a, 1224b, and 1224c are electrodes connected to terminals of circuit components 140a, 140b, and 140c, respectively. Terminal-connection electrodes 1224a, 1224b, and 1224c are connected to back surface electrodes for terminal connection (hereinafter also referred to as "back-surface terminal-connection electrodes") 1324 provided on the back surface layer via a wiring pattern (not illustrated) disposed on an inner layer of circuit board 120.

Ground electrode 1222 is an electrode that is conductively connected to the conductive component of shield 110 and grounds shield 110. Since shield 110 is grounded by ground electrode 1222, by forming slot 112 in shield 110, it is possible to realize electronic component 100 that functions as a slot antenna. Ground electrode 1222 is connected to back surface electrode for ground 1322 (hereinafter also referred to as "back-surface ground electrode 1322") provided on a layer of the back surface 132 side (hereinafter also referred to as "back surface layer" that is an example of the second layer) via a wiring pattern (not illustrated) disposed on the inner layer of circuit board 120. Ground electrode 1222 is an example of a conductor that is conductively connected to the conductive component of shield 110.

In the present embodiment, ground electrodes 1222 are electrodes having a comb shape arranged in a rectangular ring shape along the outer peripheral edge of circuit board 120. Since ground electrodes 1222 are provided along the outer peripheral edge of circuit board 120, when shield 110 is provided in half-cut groove 170 formed on the outer peripheral edge of circuit board 120, a side portion of ground electrode 1222 and inner wall surface 110e of shield 110 are adjacent to each other. As a result, the conductive connection between ground electrode 1222 and the conductive component of shield 110 is formed.

Conductive member 152 is applied to the upper surface of ground electrode 1222. Conductive member 152 is made of a material containing at least one of Sn, Ag, Cu, Bi, In, Sb, Ni, Ge, Co, P, and Pb. Examples of conductive member 152 include solder containing Sn as the main component thereof. Hereinafter, for convenience of description, conductive member 152 will be referred to as "solder 152."

Since solder 152 is applied on the upper surface of ground electrode 1222 whose side portion contacts shield 110, the side portion of solder 152 also contacts shield 110. Therefore, solder 152 is also conductively connected to the conductive component of shield 110. The side portion of solder 152 and the side portion of ground electrode 1222 form a conductive connection surface to the conductive component of shield 110. As a result, the area of the conductive connection surface can be increased. It should be noted that, as long as the conductive connection between solder 152 and shield 110 is ensured, the direct conductive connection between ground electrode 1222 and shield 110 is not necessarily required.

The side portion of solder 152 that contacts inner wall surface 110e of shield 110 is alloyed with the conductive component distributed in inner wall surface 110e to form alloy joint portion 156. Solder 152 applied to ground electrode 1222, which should be conductively connected to the conductive component of shield 110, is alloyed with the conductive component of shield 110. With such a configuration, the connection resistance between ground electrode 1222 and shield 110 can be stably reduced, and the increase in the connection resistance between ground electrode 1222 and shield 110 can be suppressed regardless of a thermal history or the like. That is, the connection reliability between circuit board 120 and shield 110 can be reliably improved.

Solder 152 and also circuit components 140a, 140b, and 140c and the like are covered with sealing resin 160. That is, solder 152 includes a lower portion, a side portion facing inner wall surface 110e of shield 110, and a remaining portion as follows: the lower portion is in contact with ground electrode 1222; the side portion is alloyed with the conductive component distributed in inner wall surface 110e; and the remaining portion is covered with sealing resin 160.

Here, sealing resin 160 may generate thermal expansion due to a thermal history or the like. In addition, when sealing resin 160 thermally expands, sealing resin 160 may enter the conductive connection surface located between ground electrode 1222 and shield 110. In this case, when the joint state between ground electrode 1222 and shield 110 on the conductive connection surface is fragile, the components may be separated at the joint, and the connection resistance may increase. However, in the present embodiment, solder 152 and the conductive component of shield 110 form alloy joint portion 156 on the conductive connection surface, and the joint state between ground electrode 1222 and shield 110 on the conductive connection surface can be firmly maintained. Therefore, even when sealing resin 160 thermally expands due to a thermal history or the like after electronic component 100 is produced, the connection between circuit board 120 and shield 110 can be stably maintained.

On the back surface layer of circuit board 120, electrodes for monitor (hereinafter also referred to as "monitor electrode(s)") 1328a and 1328b are provided in addition to back-surface ground electrodes 1322 and back-surface terminal-connection electrodes 1324. In the present embodiment, four monitor electrodes 1328a and 1328b including two monitor electrodes 1328a and two monitor electrodes 1328b are provided. Monitor electrodes 1328a and 1328b are connected to corresponding back surface side wiring lines 1326a and 1326b, and are further connected to corresponding front surface side wiring lines 1226a and 1226b via an inner layer wiring pattern (not illustrated). Front surface side wiring lines 1226a and 1226b are electrically connected to shield 110 and/or ground electrode 1222.

As a result, monitor electrodes 1328a and 1328b constitute a circuit for monitoring the connection resistance between shield 110 and ground electrode 1222. Therefore, the connection resistance between shield 110 and ground electrode 1222 can be measured at any time even after electronic component 100 is produced, and it can be checked whether or not the connection resistance is maintained at an appropriate level. Therefore, the connection reliability between circuit board 120 and shield 110 by solder 152 can be ensured over a long period of time.

In the present embodiment, the circuit for monitoring the connection resistance between shield 110 and ground electrode 1222 is composed of four monitor electrodes 1328a and 1328b. That is, the circuit has a configuration such that accurate electrical resistance measurement can be performed by a four-terminal method. However, the circuit may be a circuit for measuring electrical resistance by another method such as a two-terminal method.

As described above, ground electrodes 1222 are electrodes having a comb shape. Ground electrode 1222 is the target for cutting in a half dicing step. When ground electrodes 1222 have a configuration such that ground electrodes 1222 are continuously arranged in a rectangular ring shape along the outer peripheral edge of circuit board 120, stress may be concentrated on a local portion of ground electrode 1222 when ground electrode 1222 is cut in the half dicing step, and dicing defects may occur. In this regard, when ground electrodes 1222 are comb-shaped electrodes, the occurrence of stress concentration in the half dicing step and thus the occurrence of dicing defects can be suppressed, and the yield of electronic component 100 can be improved.

In the present embodiment, comb-shaped ground electrodes 1222 have line width W, which is the width of each individual ground electrode 1222, of 200 µm, and line spacing G, which is the distance between adjacent ground electrodes 1222, of 50 µm. By making line width W larger than line spacing G in this manner, a region in which solder 152 is applied, particularly the width of the region, can be increased. Accordingly, the contact area between solder 152 and conductive component of the shield 110 can be increased.

It is preferable that line width W of ground electrode 1222 is 100 µm or more. The setting of line width W of ground electrode 1222 is substantially equal to setting a maximum width of solder 152 applied to ground electrode 1222. This is because, when solder 152 is applied in a size larger than line width W of ground electrode 1222, a defect in which solder 152 flows into an undesirable region on front surface 122 of circuit board 120 may occur. In consideration of this point, it is preferable that line width W of ground electrode 1222 has a certain or greater value. Further, for example, when solder 152 is applied by screen printing, it is important that solder 152 is easily peeled off from a metal mask. Even in consideration of this point, it is preferable that line width W of ground electrode 1222 has a certain or greater value. The width of solder 152 that allows solder 152 to be easily peeled off from the metal mask is, for example, 100 µm. Therefore, as described above, it is preferable that line width W of ground electrode 1222, which determines the width of solder 152, is 100 µm or more.

On the other hand, when line width W of ground electrode 1222 is excessively large, solder 152 before solidification may spread excessively in the width direction. In such a case, the thickness of solder 152 is reduced, and as a result, the contact region between solder 152 and shield 110 has a line shape with no height. In order to allow the region in which solder 152 and the conductive component of shield 110 are alloyed to have a certain or greater size, it is preferable that the contact region between solder 152 and shield 110 has a certain or greater height. Therefore, in order to restrict the spreading of solder 152 in the width direction and to achieve an enough height of the contact region, it is preferable that line width W of ground electrode 1222 is a certain value or less, for example, 500 µm or less.

### (Method for producing Electronic Component)

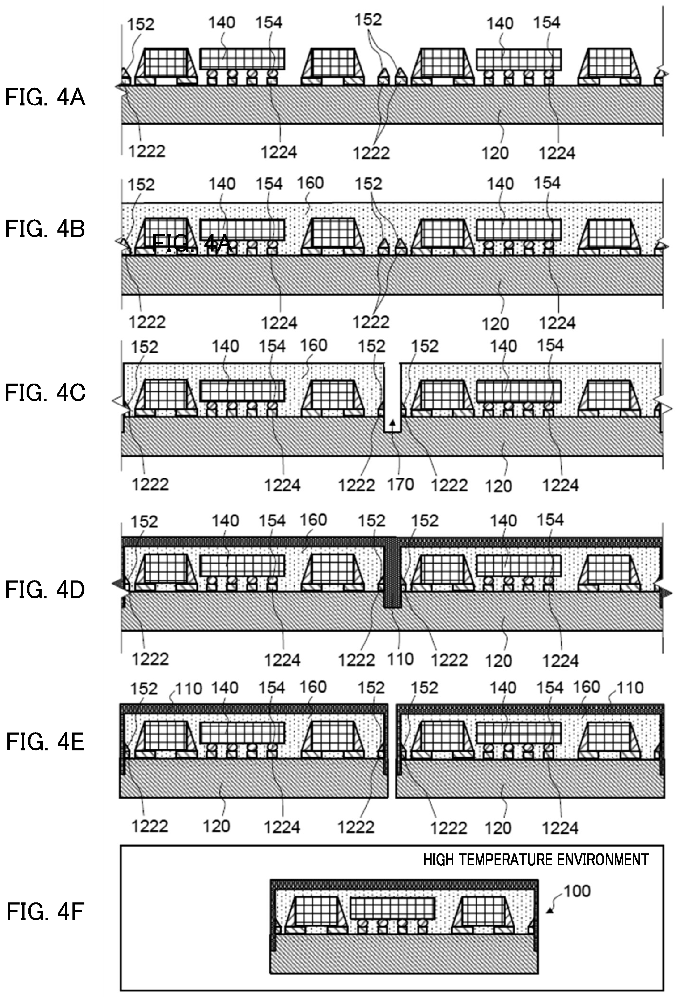

Subsequently, a method for producing electronic component 100 will be described. FIGS. 4A to 4F illustrate steps of the method for producing electronic component 100 in an execution order.

The first step illustrated in FIG. 4A is a reflow mounting step. In the reflow mounting step, circuit components 140a to 140c (hereinafter, for convenience of description, referred to as "circuit component(s) 140") are reflow-mounted on terminal-connection electrodes 1224a to 1224c (hereinafter, for convenience of description, referred to as "terminal-connection electrode(s) 1224") on front surface 122 of circuit board 120. More specifically, first, solder 152 in a cream state and solder 154a to solder 154c (hereinafter, for convenience of description, referred to as "solder 154") are applied onto ground electrode 1222 and terminal-connection electrodes 1224 by screen printing. Then, circuit component 140 is placed on solder 154 in a cream state, and circuit board 120 is heated in a reflow furnace or the like. As a result, solder 154 in a cream state is temporarily melted and then solidified to fasten circuit component 140. At this time, solder 152 on ground electrode 1222 also solidifies.

Circuit board 120 is in a state of a multiple-panel board in which a plurality of module boards are connected in a front-to-back and left-to-right direction until it is separated into individual pieces in a later step.

The second step illustrated in FIG. 4B is a resin sealing layer forming step. In the resin sealing layer forming step, a layer of sealing resin 160 is formed in such a way that components on front surface 122, namely ground electrodes 1222, the terminal-connection electrodes 1224, solder 152, solder 154a, and all of circuit components 140, are embedded.

The third step illustrated in FIG. 4C is a half dicing step (or a "groove processing step"). In the half dicing step, half-cut groove 170 is formed at a boundary portion of the module board. Half-cut groove 170 has a depth that penetrates the layer of sealing resin 160 and reaches an intermediate position of circuit board 120 in the thickness direction thereof. Ground electrode 1222 and solder 152 located at an end portion of the module board are partially removed to form side portions flush with each other (conductive connection surface).

The fourth step illustrated in FIG. 4D is a shield layer forming step. In the shield layer forming step, a layer of shield 110 made of the conductive resin material is formed to cover the upper surface of sealing resin 160 and to completely fill half-cut groove 170.

The fifth step illustrated in FIG. 4E is a full dicing step (or a "singulation step"). In the full dicing step, the module board is completely cut at the central position of half-cut groove 170 in the width direction thereof, and circuit board 120 is singulated.

The sixth step illustrated in FIG. 4F is a heat treatment step. In the heat treatment step, each circuit board 120 is disposed in a temperature environment exceeding the melting point of solder 152 and is heated. As a result, solder 152 is melted and alloyed with the conductive component of shield 110 to form alloy joint portion 156 (see FIG. 2), which is an intermetallic compound between solder 152 and the conductive component of shield 110.

Since the heating target in the heat treatment step is solder 152 on ground electrode 1222 located in the end portion region of each circuit board 120, the end portion region of each circuit board 120 may be locally heated. However, when the heating of circuit board 120 is non-uniform with respect to the region of the front surface 122, circuit board 120 may be warped. Therefore, in order to prevent the warping of circuit board 120, it is preferable to uniformly heat the entire region of circuit board 120. In this case, as solder 154-that is not the heating target-on terminal-connection electrodes 1224, a solder having a melting point higher than a high-temperature environment in which the heat treatment step is performed may be used.

The method for producing electronic component 100 described above is an example. At the time of executing the sixth step illustrated in FIG. 4F, it is necessary that circuit board 120 is provided with circuit component 140, a conductor (ground electrode 1222) that is conductively connected to the conductive component of shield 110, and solder 154 that is in contact with both the conductive component and the conductor. However, a process of preparing such circuit board 120 is not limited to the above-described example, and various changes can be made and implemented. For example, the full dicing step can be executed after the heat treatment step as long as the warping of circuit board 120 can be prevented.

### (Effect of Alloying)

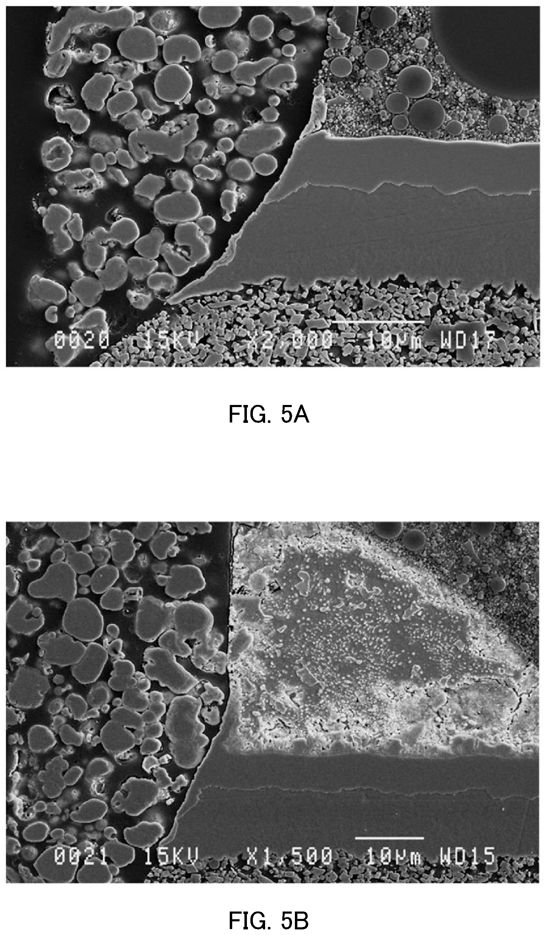

FIGS. 5A and 5B are SEM images capturing contact states in the electronic component according to a conventional example and in electronic component 100 according to Embodiment 1 between the ground electrode and the conductive component of the shield. The range of each SEM image corresponds to a range illustrated as the enlarged view of the main part in FIG. 2. The conventional example described here is, for example, a configuration such that the solder is not used for the conductive connection between the ground electrode and the shield, as in the electronic component described in PTL 1.

In the conventional example (FIG. 5A), the ground electrode and the conductive component distributed in a granular shape on the inner wall surface of the shield are not in close contact with each other, and a satisfactory conductive connection is not always formed. On the other hand, in the present embodiment (FIG. 5B), the ground electrode and the conductive component distributed in a granular shape on the inner wall surface of the shield are in close contact with each other (corresponding to alloy joint portion 156 illustrated in FIG. 2), and a satisfactory conductive connection is formed.

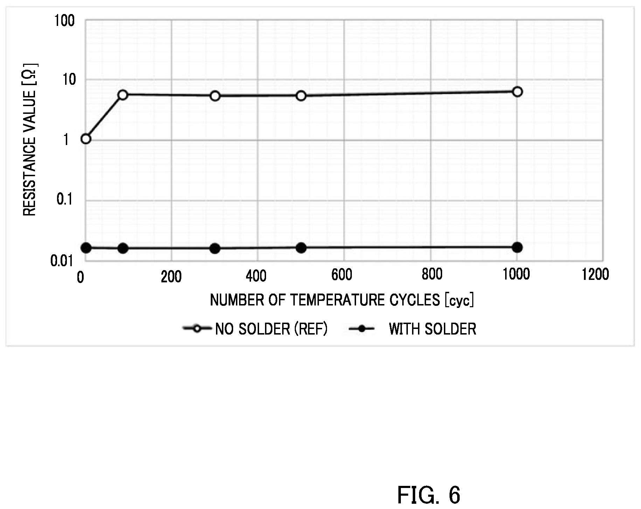

FIG. 6 is a graph for comparing a change in connection resistance due to a thermal history between the electronic component according to the conventional example and the electronic component according to Embodiment 1.

As illustrated in FIG. 6, in the conventional example (in FIG. 6, "No solder"), the resistance value of the connection resistance between the ground electrode and the shield is high from an initial stage of the thermal history, and the resistance value further increases as the number of temperature cycles increases. On the other hand, in the present embodiment (in FIG. 6, "With solder"), a state in which the resistance value of the connection resistance between ground electrode 1222 and shield 110 is low is maintained consistently from the initial stage of the thermal history until the number of temperature cycles reaches 1,000 cycles.

### (Embodiment 2)

Hereinafter, an electronic component according to Embodiment 2 of the present invention will be described. The configuration of electronic component 200 according to the present embodiment described below is basically the same as the configuration of electronic component 100 according to Embodiment 1. Therefore, the same reference numerals will be given to the configurations of electronic component 200 common to those of electronic component 100 described in Embodiment 1, and the detailed description thereof will be omitted. In the following description, the differences from Embodiment 1 will be mainly described.

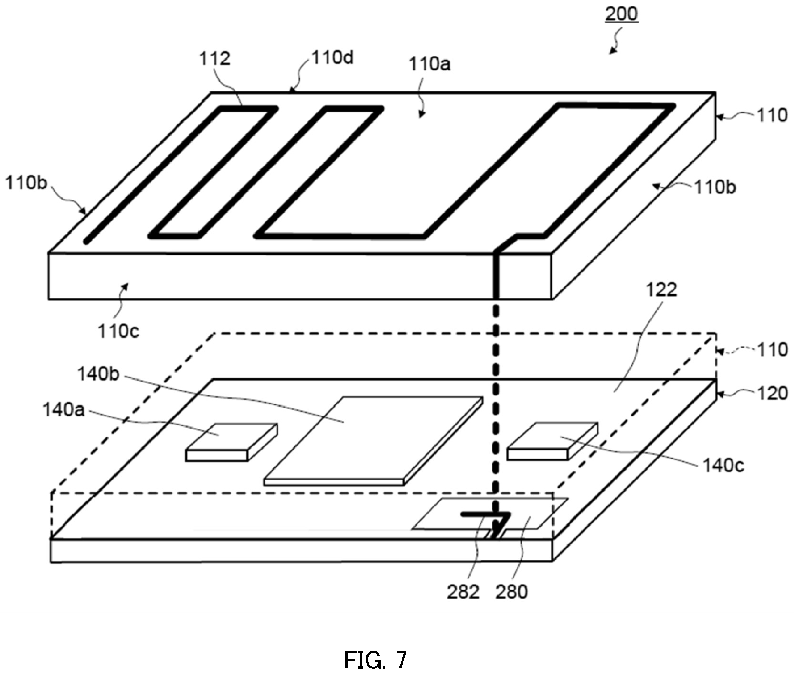

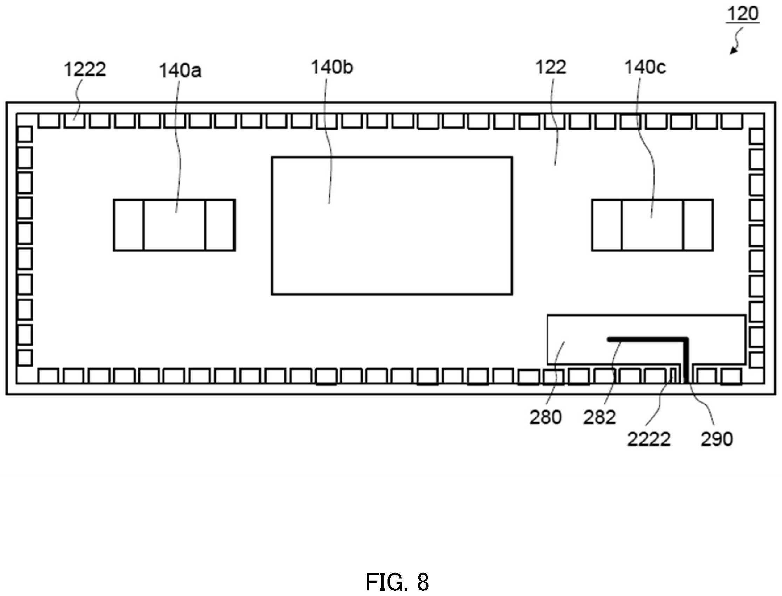

FIG. 7 is a diagram for describing a schematic configuration of electronic component 200 according to the present embodiment. FIG. 8 schematically illustrates a configuration on the front surface 122 side of circuit board 120 in electronic component 200.

Electronic component 200 is different from electronic component 100 according to Embodiment 1 in that slot 282 (second slot) that functions as the slot antenna is provided at a position different from that of slot 112 provided on top surface portion 110a of shield 110, specifically, slot 282 is provided on front surface 122 of circuit board 120.

Although the slot may be provided on back surface 132 (see FIG. 1C) of circuit board 120, in the present embodiment, the case where slot 282 is provided on the front surface 122 of circuit board 120 will be described.

In the present embodiment, a part of front surface 122 of circuit board 120 is covered with metal plate 280, and a pattern of slot 282 is formed on metal plate 280.

One end portion of the pattern of slot 282 is connected to one end portion of slot 112 formed on front wall portion 110c of shield 110. As a result, slot 282 provided on circuit board 120 and slot 112 provided on shield 110 can form an integrated slot antenna.

The connection position between slots 112 and 282 is a part of the outer peripheral edge of circuit board 120. Therefore, ground electrodes 1222 disposed on the outer peripheral edge of circuit board 120 are partially removed to avoid the connection position between slots 112 and 282. In the present embodiment, line width W of ground electrode 2222 adjacent to the connection position between the slots 112 and 282 is reduced. In this manner, ground electrodes 1222 and 2222 and solder 152 (see FIG. 2 and the like) disposed on the upper portions of ground electrodes 1222 and 2222 are disposed at positions different from the connection position between slots 112 and 282. In such a disposition, ground electrodes 1222 and 2222 and solder 152 on the upper portions of ground electrodes 1222 and 2222 do not come into contact with slots 112 and 282, and therefore the function of the slot antenna is not hindered by ground electrodes 1222 and 2222.

Although the embodiments of the present invention have been described in detail above, the present invention is not limited to the specific embodiments described above. Various modifications and changes can be made to the specific examples described in the embodiments within the gist of the present invention described in the claims.

This application is entitled to and claims the benefit of Japanese Patent Application No. 2023-132282 filed on August 15, 2023, the disclosure of which including the specification, drawings and abstract is incorporated herein by reference in its entirety.

### Industrial Applicability

The present invention can be suitably used for, for example, an electronic component having a configuration such that a shield that shields a circuit component mounted on a board from the outside is provided.

### Reference Signs List

100, 200 Electronic component
110, 210 Shield
110a Top surface portion
110b Side wall portion
110c Front wall portion
110d Rear wall portion
110e Inner wall surface
112, 282 Slot
120 Circuit board
122 Front surface
1222, 2222 Ground electrode
1224a, 1224b, 1224c Terminal-connection electrode
1226a, 1226b Front surface side wiring line
132 Back surface
1322 Back-surface ground electrode
1324 Back-surface terminal-connection electrode
1326a, 1326b Back surface side wiring line
1328a, 1328b Monitor electrode
140a, 140b, 140c Circuit component
152 Conductive member (for example, solder)
154a, 154b, 154c Solder
156 Alloy joint portion
160 Sealing resin
170 Half-cut groove
280 Metal plate
290 Lead portion
G Line spacing
W Line width

## Claims

1. An electronic component comprising:
a board provided with a circuit component, a conductor, and a conductive member, the conductor being conductively connected to a conductive component of a shield shielding the circuit component from an outside of the electronic component, the conductive member being in contact with both the conductive component and the conductor, wherein
the conductive member is alloyed with the conductive component.

2. The electronic component according to claim 1, wherein
the conductive member includes a lower portion, a side portion facing an inner wall surface of the shield, and a remaining portion, the lower portion being in contact with the conductor, the side portion being alloyed with the conductive component distributed in the inner wall surface, the remaining portion being covered with a sealing resin.

3. The electronic component according to claim 1, wherein:
the conductive member is disposed on an electrode of the electronic component; and
a side portion of the conductive member and a side portion of the conductor form a conductive connection surface to the conductive component.

4. The electronic component according to claim 3, wherein:
the conductor is the electrode having a comb shape and disposed in a first layer of the board; and
a line width of the electrode is greater than a line spacing between electrodes among a plurality of the electrodes.

5. The electronic component according to claim 4, wherein
the line width of the electrode is 100 µm or more.

6. The electronic component according to claim 5, wherein
the line width of the electrode is 500 µm or less.

7. The electronic component according to claim 1, wherein:
the conductor is a ground electrode;
a monitor electrode is provided on a second layer of the board;
the monitor electrode is electrically connected to the shield and/or the ground electrode via wiring; and
the monitor electrode forms a circuit for monitoring connection resistance between the shield and the ground electrode.

8. The electronic component according to claim 1, wherein
the shield is provided with a groove forming a void that is free of the conductive component.

9. The electronic component according to claim 8, wherein
the groove functions as a slot of a slot antenna.

10. The electronic component according to claim 9, wherein:
the conductor is disposed on a first layer of the board, and the conductive member is disposed on the conductor;
a second slot is provided on the first layer of the board so as to be connected to the slot, the second slot and the slot functioning as the slot antenna, and
the conductor and the conductive member are disposed at positions different from a connection position between the slot and the second slot.

11. A method for producing an electronic component, the method comprising:
preparing a board provided with a circuit component, a conductor, and a conductive member, the conductor being conductively connected to a conductive component of a shield shielding the circuit component from an outside of the electronic component, the conductive member being in contact with both the conductive component and the conductor; and
heat-treating the board at a temperature exceeding a melting point of the conductive member to alloy the conductive member with the conductive component.
